# EUROPEAN PATENT SPECIFICATION

(11) **EP 3 637 533 B1**
(45) Date of publication and mention of the grant of the patent: **29.01.2025**
(21) Application number: 19201928.9
(22) Date of filing: 08.10.2019
(51) Int. Cl.: H01M 10/42, H01M 10/44, H01M 10/48, H01M 10/613, H01M 10/615, H01M 10/63, H01M 10/651, H01M 10/656, B60R 16/033, H01M 50/569

(54) **A METHOD OF OPERATING A STORAGE BATTERY DEVICE**
VERFAHREN ZUM BETREIBEN EINER SPEICHERBATTERIEVORRICHTUNG
PROCÉDÉ POUR FAIRE FONCTIONNER UN DISPOSITIF À BATTERIE DE STOCKAGE

(30) Priority: 09.10.2018 JP 2018190930
(43) Date of publication of application: 15.04.2020
(73) Proprietor: Kabushiki Kaisha Toshiba, Minato-ku Tokyo 105-0023 (JP); Toshiba Infrastructure Systems & Solutions Corporation, Kawasaki-shi, Kanagawa 212-0013 (JP)
(72) Inventor: Kondo, Atsumi, Tokyo, 105-0023 (JP); Hagiwara, Keizo, Kanagawa, 212-0013 (JP)
(74) Representative: AWA Sweden AB

(56) References cited:
- EP-B1- 3 703 991
- DE-A1- 102011 103 974
- JP-A- 2017 045 700
- US-A1- 2015 280 294

## Description

### FIELD

Embodiments described herein relate generally to a method of operating a storage battery device.

### BACKGROUND

Recently, development has been advanced on a storage battery device for a vehicle, aiming to improve fuel efficiency of the vehicle through the provision of a storage battery device including a storage battery and a fail-safe device in the vehicle, and capable of transporting passengers to a safe place using power supplied from the storage battery device in case of emergency when feeding from an external source, such as overhead lines, is interrupted.

Such a storage battery device for a vehicle comprises a plurality of assembled batteries. The assembled batteries are connected in series or in parallel with each other, so as to output a desired current and voltage. Since a storage battery device for a vehicle is often installed in a limited space in an existing vehicle, a plurality of assembled batteries need to be arranged in proximity to each other, to install a larger number of assembled batteries in the storage battery device.

C-rate is often used as a measure of the input/output performance of a battery cell. The C-rate is a measure of the rate at which the current can be charged (input) or discharged (output) relative to the rated current of a battery cell. For example, assuming that the rated current of a battery cell is 10 [Ah] and its C-rate is 4C, the input/output performance of the battery cell is given as 40[A].

By increasing the number of battery cells arranged in parallel, the current load on a unit cell can be reduced. Also, by decreasing the C-rate of a battery cell, the amount of heat generated in a unit cell can be reduced, thus facilitating the designing of a cooling system.

On the other hand, as the number of battery cells arranged in parallel increases, the number of battery cells installed in the storage battery device also increases, resulting in an increase in the weight of the storage battery device. Moreover, as the number of battery cells increases, it becomes more difficult to reduce the cost of the storage battery device. Furthermore, the increase in the number of battery cells installed in the storage battery device increases the size of the outer shape of the storage battery device, rendering it difficult to save space.

From the above-described circumstances, it is desirable that the number of battery cells installed in a storage battery device be small. However, since the current increases during rapid charging or discharging, the state of charge (SOC) may vary over a wide range, e. g. , from 10% to 90%, in a short period of time. When the SOC greatly varies in such a short period of time, it is difficult to use battery cells in a wide range of SOCs, since battery cells with a high internal resistance, e.g., at an SOC close to 10% or 90%, with their voltages reaching the upper or lower limit, are used.

Prior art methods of operating a battery are disclosed in US2015280294A1 and DE102011103974A1.

### BRIEF DESCRIPTION OF THE DRAWINGS

FIG. 1 is a schematic diagram showing a configuration example of a storage battery device according to a first embodiment.
FIG. 2 shows an example of a relationship between the charging and discharging power of a battery cell and its voltage.
FIG. 3 shows an example of a relationship between the SOC of a battery cell and its internal resistance value during charging, with respect to various temperatures of the battery cell.
FIG. 4 shows an example of a relationship between the SOC of a battery cell and its internal resistance value during discharging, with respect to various temperatures of the battery cell.
FIG. 5 is a flowchart illustrating an example of an operation of a battery temperature controller of a storage battery device according to an embodiment.
FIG. 6 shows an example of a charging and discharging schedule of a plurality of battery modules and temperature changes of a battery cell.
FIG. 7 is a flowchart illustrating an example of an operation of a battery temperature controller of a storage battery device according to an embodiment.
FIG. 8 shows an example of a table storing internal resistance values, each corresponding to the temperature and the SOC of a battery cell.
FIG. 9 shows an example of the positions of arrangement of high-temperature and low-temperature battery cells in an assembled battery.
FIG. 10 shows an example of the positions of arrangement of high-temperature and low-temperature battery cells in a battery module including a plurality of assembled batteries.
FIG. 11 is a diagram illustrating an example of temperature control of battery cells in a storage battery device according to a second embodiment.
FIG. 12 is a diagram illustrating an example of temperature control of the battery cells in the storage battery device according to the second embodiment.
FIG. 13 is a flowchart illustrating an example of an operation of a storage battery device according to a third embodiment.
FIG. 14 shows an example of charging and discharging power of a plurality of battery modules and temperature changes of a battery cell.

### DETAILED DESCRIPTION

A storage battery device according to an embodiment comprises at least one battery module comprising an assembled battery including a plurality of battery cells, a cell monitoring unit that detects a voltage and a temperature of each of the battery cells, and a temperature adjusting unit that adjusts the temperature of each of the battery cells; a heating unit that heats a medium supplied to the temperature adjusting unit and outputs the heated medium; a cooling unit that cools the medium supplied to the temperature adjusting unit and outputs the cooled medium; and a battery management unit including a temperature detector and a battery temperature controller, the temperature detector configured to communicate with the cell monitoring unit and an outside, and to detect a temperature of the medium, the battery temperature controller performing temperature control of the battery cells by controlling the heating unit and the cooling unit to adjust a temperature of the medium in such a manner that an internal resistance value of each of the battery cells falls within a predetermined range, based on an internal resistance value corresponding to values of the temperature and the voltage of each of the battery cells received from the cell monitoring unit.

Hereinafter, a description will be given of a storage battery device according to an embodiment, with reference to the accompanying drawings.

In the embodiment described below, an example of a configuration of a storage battery device installed in a vehicle will be described.

For a storage battery device installed in a railroad vehicle, a charging and discharging schedule, for example, can be set in advance, in accordance with an operation route of each line. When the railroad vehicle runs up a long upward slope, for example, the storage battery device installed in the railroad vehicle continues outputting a torque, and a high discharge C-rate continues until the railroad vehicle climbs to the top of the slope. In this case, when the temperature of a battery cell of the storage battery device is inappropriate, the internal resistance of the battery cell may increase, resulting in insufficient discharging.

Also, when the power supply to the railroad vehicle from an external source such as overhead lines is lost by, for example, a disaster, the railroad vehicle needs to make an emergency run using the power supplied from the storage battery device, and needs to produce a desired torque until the railroad vehicle reaches a safe place. However, when, for example, power is not distributed during a normal run in winter months, rendering the temperature of the storage battery device low, the internal resistance of a battery cell is kept high. When power distribution and discharging from the storage battery device are commenced from this state, the voltage of the battery cell may reach a permissible lower-limit value or a permissible upper-limit value in a short period of time after the commencement of discharging, thus preventing desired discharging from being performed.

Also, a storage battery device installed in a railroad vehicle that runs on a line in which there is a partial or complete absence of overhead lines can be charged only in a limited unit or in a limited period of time while the vehicle is stopping at the station. It is thus necessary to complete rapid charging of the storage battery in a limited period of time, such as the period of time during which the vehicle is stopping at the station, and the storage device needs to be continuously discharged in a section in which there are no overhead lines. However, when the SOC of a battery cell is low and its temperature is low, rapid charging of the storage battery device may cause the voltage of the battery cell to reach the permissible upper-limit value, resulting in a failure to complete rapid charging.

Increasing the number of battery cells installed in the storage battery device to reduce the load on a unit cell during charging and discharging, in an effort to allow for charging and discharging of the storage battery device in the above-described situation, would increase the weight of the storage battery device, as well as the cost. In any conveyance, the upper weight limit for outfitting and loading is set for each vehicle, and a storage battery device of a weight exceeding the upper limit cannot be installed.

Thus, in the present embodiment, a description will be given of a storage battery device capable of optimizing the use of battery cells at an SOC ranging, for example, from 10% to approximately full charge, while suppressing the weight and the outer shape of the storage battery device, preventing an increase in cost.

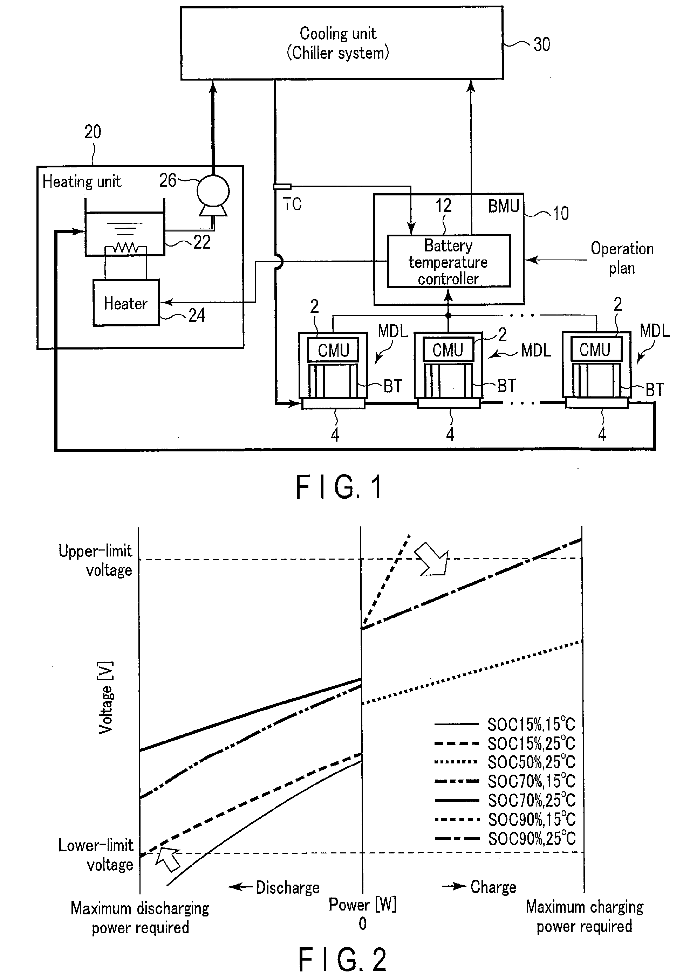

FIG. 1 is a schematic diagram showing a configuration example of a storage battery device according to a first embodiment.

The storage battery device of the present embodiment is, for example, an in-vehicle power supply, which may be installed under the floor or above the floor in a railroad vehicle, or in an engine room in the case of a locomotive.

To cope with the above-described wide range of application examples, the storage battery device of the present embodiment performs control, prior to a predetermined charging and discharging pattern or prior to a pattern in which the SOC of the battery cell suddenly drops, to adjust the temperature of a battery cell in such a manner that the internal resistance of the battery cell falls within a predetermined range.

The storage battery device of the present embodiment comprises a plurality of battery modules MDL, a battery management unit (BMU) 10, a heating unit 20, and a cooling unit (chiller system) 30.

Each of the battery modules MDL includes an assembled battery BT, a cell monitoring unit (CMU) 2, and a temperature adjusting unit 4.

The assembled battery BT includes a plurality of battery cells. It is desirable that the battery cells be storage battery cells capable of performing rapid charging and rapid discharging, and lithium ion batteries, for example, can be adopted as the battery cells.

The cell monitoring unit 2 or the battery management unit (BMU) 10 comprises a communication unit capable of communicating with the outside, a detector that detects the voltage and temperature of each of the battery cells, and periodically detects the voltage and temperature of each of the battery cells included in the assembled battery BT and outputs the detected voltage and temperature to the battery management unit 10. The cell monitoring unit 2 may further include a detector that detects the internal resistance of each of the battery cells, and may be configured to periodically output the detected internal resistance values to the battery management unit 10.

The temperature adjusting unit 4 includes, for example, a flow path through which a medium flows, and cools or heats the assembled battery BT by letting heat transferred between the medium and the assembled battery BT.

The heating unit 20 includes a container 22, a heater 24, and a pump 26. The heater 24, whose operation is controlled by the battery management unit 10, heats the medium contained in the container 22 in accordance with a temperature instruction from the battery management unit 10. The pump 26 sends the medium contained in the container 22 to the cooling unit 30.

The cooling unit 30, whose operation is controlled by the battery management unit 10, cools the medium flowing from the heating unit 20 and sends the cooled medium to the battery modules MDL, in accordance with a temperature instruction from the battery management unit 10.

The battery management unit 10 includes a higher-level device, a communication unit (not illustrated) capable of communicating with the cell monitoring units 2 of the battery modules MDL, a battery temperature controller 12, and a temperature detector TC.

The temperature detector TC detects the temperature of the medium sent from the cooling unit 30 to the battery modules MDL.

The battery management unit 10 receives values corresponding to the voltage, the temperature, and the internal resistance of each of the battery cells from the cell monitoring units 2 of the battery modules MDL, and computes the SOC of each of the battery cells (or the assembled batteries BT).

The battery management unit 10 acquires an operation plan from the higher-level control device and controls charging and discharging of the battery modules according to the operation plan, and controls the temperature of each of the assembled batteries BT by controlling the heating unit 20 and the cooling unit 30.

The battery management unit 10 may include, for example, at least one processor, and a memory storing thereon a program to be executed by the processor, and may be configured to implement the operations that will be described below by software.

The battery temperature controller 12 includes a table storing internal resistance values, each corresponding to the temperature and the SOC of a battery cell, and controls the heating unit 20 and the cooling unit 30 using the temperature of the medium detected by the temperature detector TC, the computed SOC of each of the battery cells, and the voltage and temperature of each of the battery cells received from the cell monitoring units 2 of the battery modules MDL, thereby adjusting the temperature of each of the assembled batteries BT of the battery modules MDL.

A description will be given of an example of a relationship between the internal resistance, the temperature, and the SOC of a battery cell.

FIG. 2 shows an example of a relationship between the charging and discharging power of a battery cell and its voltage.

For the voltage of the battery cell, a permissible upper-limit value (upper-limit voltage value) and a permissible lower-limit value (lower-limit voltage value) are set. Also, the maximum value of power for charging the battery cell (maximum charging power) and the maximum value of power for discharging the battery cell (maximum discharging power) are set.

Charging and discharging of a battery cell are performed within the range in which the voltage of the battery cell is equal to or greater than the lower-limit value and is equal to or lower than the upper-limit value. For example, when the temperature of a battery cell is 25°C and its SOC is 50%, the voltage of the battery cell becomes equal to or greater than the lower-limit value and equal to or lower than the upper-limit value even when the battery cell is charged at the maximum charging and discharging power, and charging can be performed at a high C-rate.

On the other hand, when the SOC of a battery cell is 90% and its temperature is 25°C, the voltage of the battery cell rises above the upper-limit voltage value when the charging power reaches its maximum, and charging must be performed by decreasing the C-rate and the current value in such a manner that the voltage of the battery cell becomes equal to or lower than the upper-limit voltage value.

If the SOC of a battery cell is 90% and its temperature is 15°C, the voltage of the battery cell rises above the upper-limit voltage value even when the battery cell is charged at a low charging power, and charging of the battery cell needs to be performed at an even lower C-rate, which requires time until the battery cell is fully charged (i.e., until the SOC becomes 100%).

In the case of discharging a battery cell, when the temperature of the battery cell is 25°C, the voltage of the battery cell becomes equal to or greater than the lower-limit voltage value even after the discharging of the battery cell at the maximum discharging power, no matter whether the SOC is 70% or 15%, and discharging can be performed at a high C-rate.

However, when the SOC of a battery cell is 15% and its temperature is 15°C, the discharging of the battery cell at the maximum discharging power renders the voltage of the battery cell lower than the lower-limit voltage value, and the battery cell needs to be discharged at an even lower C-rate. For example, when a battery cell is used as an emergency power supply in case of loss of an external power supply in winter months or in cold climates, there is a possibility that the capacity of the battery cell cannot be used to its maximum because of the voltage of the battery cell falling below the lower-limit value.

As described above, it is because the internal resistance value of the battery cell varies according to the temperature that the amount of charging power that can be adopted varies according to the temperature, even when the SOC of the battery cell remains the same.

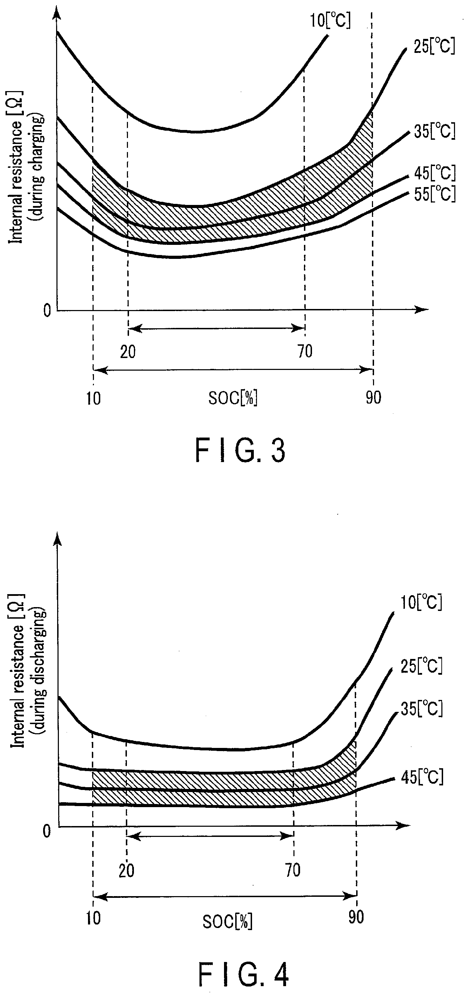

FIG. 3 shows an example of a relationship between the SOC of a battery cell and its internal resistance value during charging, with respect to various temperatures of the battery cell.

The relationship between the SOC of a battery cell and its internal resistance [Ω] is non-linear, and the value of the internal resistance during charging decreases as the temperature of the battery cell increases when the SOC remains the same. Accordingly, the voltage of a battery cell tends to increase during charging as the temperature of the battery cell decreases.

FIG. 4 shows an example of a relationship between the SOC of a battery cell and its internal resistance value during discharging, with respect to various temperatures of the battery cell.

Similarly to charging, the relationship between the SOC of a battery cell and its internal resistance [Ω] during discharging is non-linear, and the value of the internal resistance during discharging decreases as the temperature of the battery cell increases when the SOC remains the same. Accordingly, the voltage of a battery cell tends to increase during discharging, as the temperature of the battery cell decreases.

In view of the above, the storage battery device of the present embodiment controls the temperature of a battery cell in such a manner that the internal resistance value of a battery cell falls within a predetermined range, to allow for charging and discharging of battery cells in a wider range of SOCs and to lessen the load on a unit battery cell during charging and discharging.

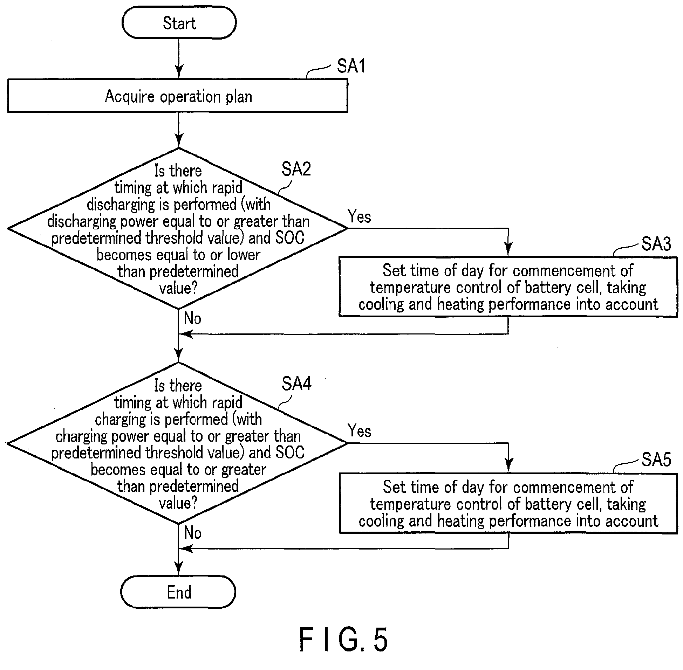

FIG. 5 is a flowchart illustrating an example of an operation of a battery temperature controller of a storage battery device according to an embodiment.

The battery temperature controller 12 receives, from an upper-level control device, an operation plan of a railroad vehicle during a predetermined period of time (e.g., one day) (step SA1) . The operation plan of a railroad vehicle may include, for example, information on the line on which the railroad vehicle runs and information on the time of day when the railroad vehicle passes through a particular point such as a station. The battery temperature controller 12 determines a charging and discharging schedule of a plurality of battery modules MDL, based on the operation plan of the railroad vehicle.

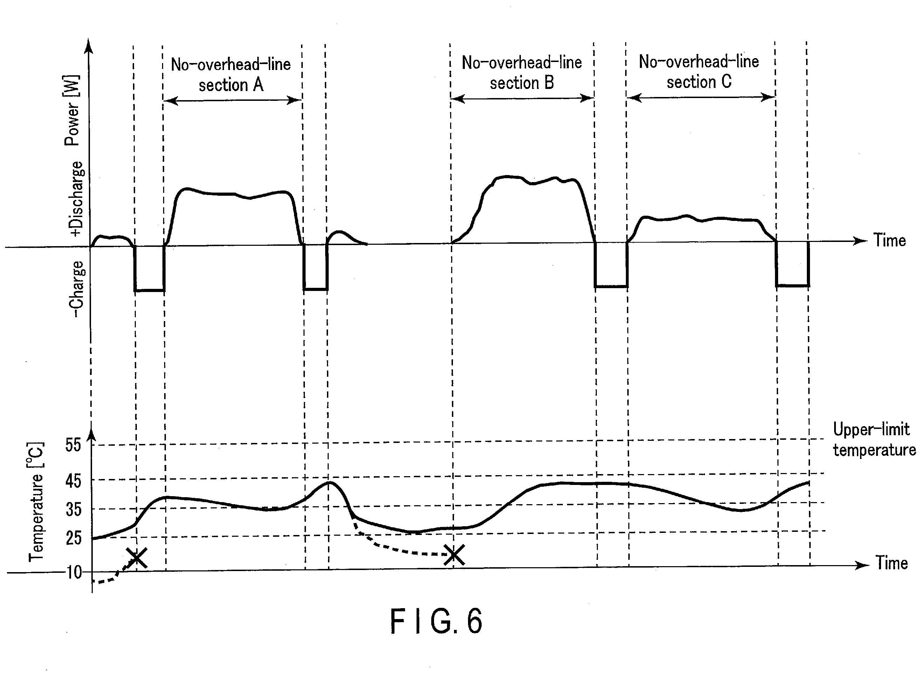

FIG. 6 shows an example of a charging and discharging schedule of a plurality of battery modules and temperature changes of a battery cell.

In this example, a case is assumed where the railroad vehicle runs through three sections (non-electrified sections) in which there are no overhead lines.

Immediately before the railroad vehicle reaches the no-overhead-line section A, a period of time (an electrified section) is provided for charging the battery modules MDL. For this charging period, it is preferable to perform charging at a high C-rate, since charging is completed in a relatively short period of time (e.g., five minutes), utilizing the period of time during which the railroad vehicle is stopping at the station.

However, when the temperature of a battery cell is originally low and does not become sufficiently high at the timing of charging the battery cell immediately before the vehicle reaches the no-overhead-line section A, as shown by the dashed line, for example, charging the battery cell at a high C-rate may cause the voltage of the battery cell to exceed the upper-limit value, resulting in failure to perform desired charging.

In the case of a battery cell at an SOC of 90%, when the temperature of the battery cell is 15°C, the voltage of the battery cell reaches its upper limit at a low charging power, as compared to when the temperature of the battery cell is 25°C. That is, in order to fully charge a battery cell in a short period of time, at a high power, and at a high C-rate, it is desirable that the temperature of the battery cell be between, for example, 25°C and 45°C.

The battery modules MDL are neither charged nor discharged in the period immediately before the railroad vehicle reaches the no-overhead-line section B. Thus, when the temperature of the battery cell is low at the timing at which the railroad vehicle commences running through the no-overhead-line section B, as shown by, for example, the dashed line, the discharging power in the no-overhead-line section B is restricted, and a predetermined operation plan may not be accomplished.

Accordingly, the battery temperature controller 12 computes a prediction value indicating a change over time of the SOC of the battery cell based on the operation plan, and determines whether or not there is a timing at which rapid discharging is performed (with the discharging power equal to or greater than a predetermined threshold value) and the SOC of the battery cell becomes equal to or lower than a predetermined value (step SA2).

Since the voltage of a battery cell may fall below the lower-limit value at the timing at which the SOC of the battery cell becomes equal to or lower than a predetermined value during rapid discharging, the temperature of the battery cell is controlled so as to fall within a predetermined range, at the commencement of rapid discharging. The battery temperature controller 12 sets the time of day for the commencement of the temperature control of the battery cell, taking the cooling and heating performance of the storage battery device into consideration (step SA3).

The battery temperature controller 12 computes a prediction value indicating a change over time of the SOC of the battery cell based on the operation plan, and determines whether or not there is a timing at which rapid charging is performed (with the charging power equal to or greater than a predetermined threshold value) and the SOC of the battery cell becomes equal to or greater than a predetermined threshold value (step SA4).

Since the voltage of a battery cell may become greater than the upper-limit value at the timing at which the SOC of the battery cell becomes equal to or greater than a predetermined value during rapid charging, the temperature of the battery cell is controlled so as to fall within a predetermined range, at the commencement of rapid charging. The battery temperature controller 12 sets the time of day for the commencement of the temperature control of the battery cell, taking the cooling and heating performance of the storage battery device into consideration (step SA5).

In the present embodiment, temperature control of a battery cell during rapid charging and rapid discharging has been described; however, the battery temperature controller 12 may control the temperature of the battery cell according to the value of the SOC of the battery cell even when the C-rate is equal to or lower than a predetermined value. In this case, it is possible to set in advance the temperature of a battery cell to be controlled at the point in time when the internal resistance of the battery cell becomes high, by suitably adjusting, for example, the threshold value of the discharging power and the threshold value of the charging power in steps SA2 and SA4 shown in FIG. 5.

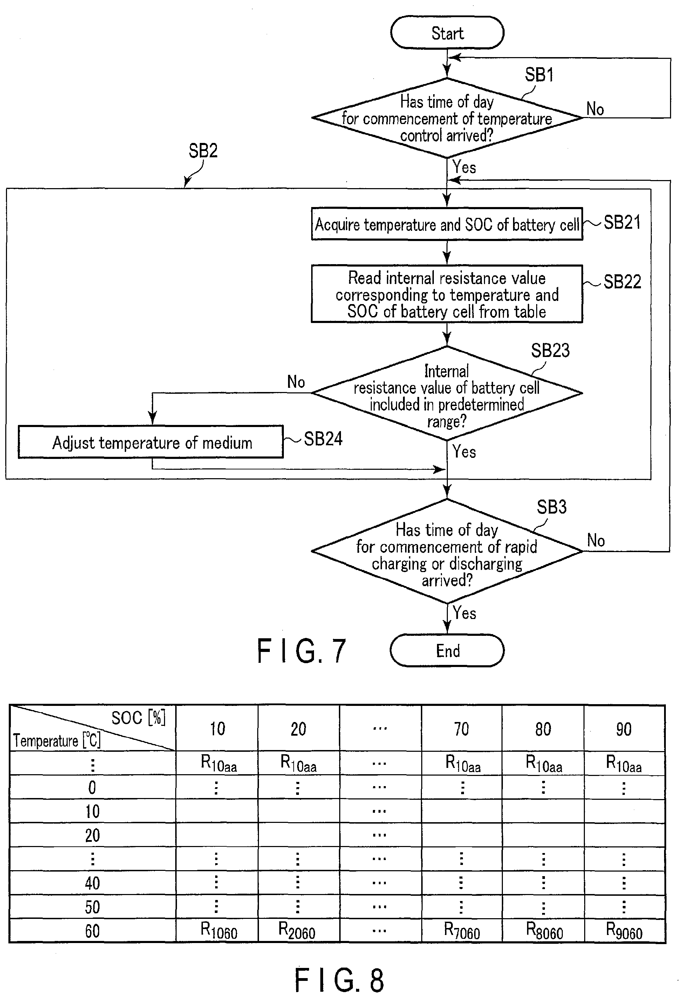

FIG. 7 is a flowchart illustrating an example of an operation of a battery temperature controller of a storage battery device according to an embodiment.

The battery temperature controller 12 determines whether or not the time of day has arrived for the commencement of temperature control of battery cells (step SB1), and when it is determined that the time of day for the commencement has arrived, the temperature control of the battery cells is performed in such a manner that the internal resistance value of each of the battery cells falls within a predetermined range (step SB2).

Specifically, the battery temperature controller 12 acquires the temperature and the SOC of each of the battery cells (step SB21).

Thereafter, the battery temperature controller 12 finds an internal resistance value of each of the battery cells by referring to a table of internal resistance values, each corresponding to the temperature and the SOC value of a battery cell (step SB22).

FIG. 8 shows an example of a table storing internal resistance values, each corresponding to the temperature and the SOC of a battery cell.

The battery temperature controller 12 is capable of reading, from the table, the corresponding internal resistance value of each of the battery cells, using the temperature of each of the battery cells received from the cell monitoring unit 2 and the computed SOC value.

The value of the internal resistance of a battery cell varies according to the state of deterioration caused by, for example, the duration of use of the battery cell. Accordingly, in order to find more accurate internal resistance values, the battery temperature controller 12 may correct the values stored in the table based on the duration and history of use of the battery cells, and a table corresponding to each of the deterioration states may be provided.

Thereafter, the battery temperature controller 12 determines whether or not the internal resistance values of the battery cells fall within a predetermined range (step SB23). At this time, the battery temperature controller 12 may determine whether or not both the largest value and the smallest value among the internal resistance values are included in a predetermined range, or whether or not a mean value of the internal resistance values of the battery cells is included in a predetermined range.

If it is determined that the internal resistance value of each of the battery cells is not included in the predetermined range, the battery temperature controller 12 adjusts the temperature of the medium (step SB24). That is, when it is determined that the internal resistance value of each of the battery cells is equal to or greater than a predetermined threshold value, the battery temperature controller 12 outputs a temperature instruction to the heater 24 of the heating unit 20 to increase the temperature of the medium. If it is determined that the internal resistance value of each of the battery cells is equal to or lower than a predetermined threshold value, the battery temperature controller 12 outputs a temperature instruction to the cooling unit 30 to decrease the temperature of the medium.

The battery temperature controller 12 adjusts the temperature of the medium, as described above, and controls the temperature of each of the battery cells in such a manner that the internal resistance value of each of the battery cells falls within a predetermined range, until the time of day for the commencement of rapid charging or discharging of the battery modules MDL comes. When the temperature of each of the battery cells has become equal to or greater than a predetermined temperature, the battery temperature controller 12 may adjust the temperature of the medium to prevent the temperature of each of the battery cells from becoming equal to or greater than a threshold value, to preferentially suppress deterioration of the battery cells.

The battery temperature controller 12 terminates the temperature control of the battery cells when the time of day for the commencement of rapid charging or discharging of the battery modules MDL has arrived (step SB3).

The battery temperature controller 12 controls the heating unit 20 and the cooling unit 30 in such a manner that the temperature of each of the battery cells does not become equal to or greater than the permissible upper-limit value or the permissible lower-limit value, even during a period other than the period in which the temperature control based on the internal resistance values of the battery cells is performed, as described above, thereby preventing the temperature of each of the battery cells from becoming overly high or low.

Next, a description will be given of an advantageous effect of the present embodiment, with reference to the charging and discharging schedule of the battery modules and the temperature changes of a battery cell shown in FIG. 6.

Immediately before a railroad vehicle reaches the no-overhead-line section A, a period of time is provided for charging the battery modules MDL. For this charging period, it is preferable to perform charging at a high C-rate, since charging is completed in a relatively short period of time, utilizing the period of time during which the railroad vehicle is stopping at the station.

In the storage battery device of the present embodiment, when charging is commenced at a high C-rate, temperature management is performed from the commencement of operation to the commencement of charging, by commencing operation after heating the battery cells in advance, as necessary, in such a manner that the internal resistance value of each of the battery cells falls within a predetermined range. Thereby, the internal resistance of each of the battery cells at the commencement of charging falls within a predetermined range, and charging can be completed in a relatively short period of time.

The battery modules MDL are neither charged nor discharged in the period immediately before the railroad vehicle reaches the no-overhead-line section B. In the present embodiment, the battery temperature controller 12 commences temperature control of the battery cells before the railroad vehicle runs through the no-overhead-line section B, in such a manner that the internal resistance of each of the battery cells falls within a predetermined range, at the timing at which the railroad vehicle commences running through the no-overhead-line section B. Thereby, the internal resistance of each of the battery cells at the commencement of discharging falls within a predetermined range, and feeding from the storage battery device can be performed while the vehicle is running through a no-overhead-line section.

For example, when rapid charging is performed while a vehicle is stopping at the station, or when discharging is performed at a high C-rate for a long period of time to output a torque while a vehicle is climbing up an upward slope, the amount of heat generated in each of the battery cells increases.

Since the point in time when the voltage of each of the battery cells may possibly exceed the upper-limit value or the lower-limit value can be known in advance when, for example, the operation plan is known in advance, as in the above-described case, it is possible to perform temperature control of the battery cells in such a manner that the internal resistance of each of the battery cells falls within a predetermined range at that point in time. It is thereby possible to optimize the use of the battery cells installed in the storage battery device at an SOC ranging from 0% to approximately full charge, and to improve the charging and discharging performance of the storage battery device, without increasing the number of the battery cells.

Moreover, it is possible to provide a storage battery device capable of suppressing increases in weight and outer shape of the storage battery device, while also suppressing increase in cost.

Next, a detailed description will be given of a storage battery device according to a second embodiment, with reference to the accompanying drawings.

In the description that follows, structural elements similar to those of the storage battery device of the first embodiment will be denoted by the same reference numerals, and descriptions of such elements will be omitted.

In the present embodiment, an example of temperature control will be described in which a temperature gradient is caused by the positions in which the battery cells installed in the battery modules MDL are arranged.

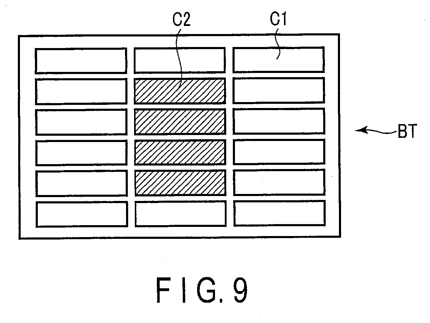

FIG. 9 shows an example of the positions of arrangement of high-temperature battery cells and low-temperature battery cells in an assembled battery.

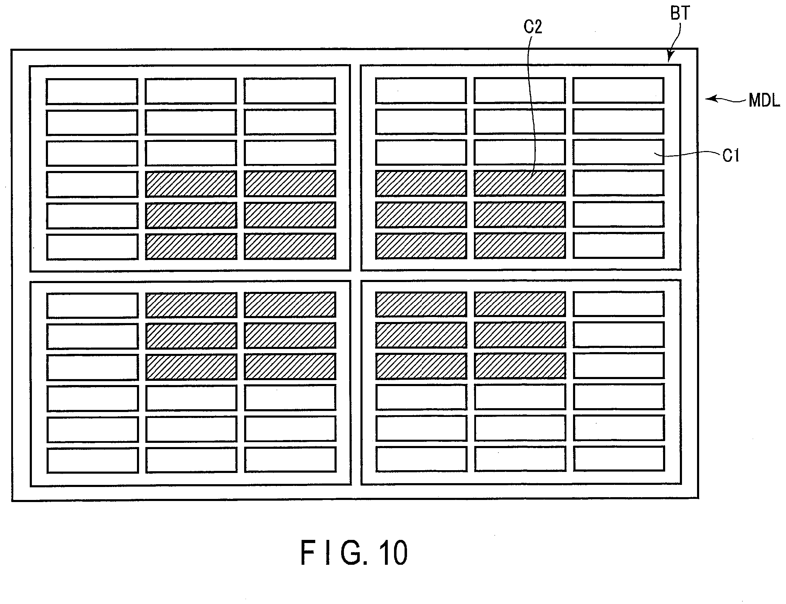

FIG. 10 shows an example of the positions of arrangement of high-temperature battery cells and low-temperature battery cells in a battery module including a plurality of assembled batteries.

An example will be described where low-temperature battery cells C1 and high-temperature battery cells C2 are included in an assembled battery BT. In a battery module MDL including a single assembled battery BT, for example, a battery cell arranged in a region surrounded by other battery cells tends to have a high temperature. Similarly, in a battery module MDL including a plurality of assembled batteries BT, for example, a battery cell arranged inside, surrounded by a plurality of battery cells, tends to have a high temperature.

In the present embodiment, temperature control of the battery cells is performed by focusing on the highest-temperature battery cell and the lowest-temperature battery cell in the battery module MDL.

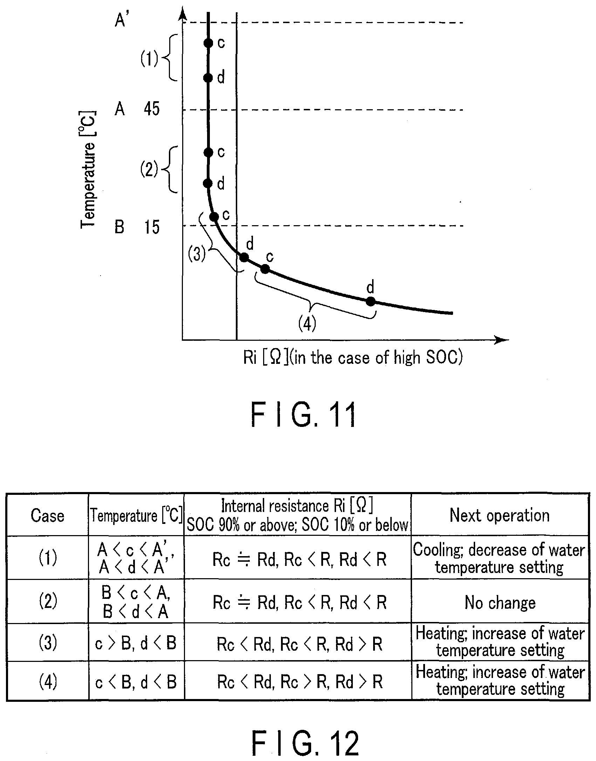

FIG. 11 is a diagram illustrating an example of temperature control of battery cells in a storage battery device according to a second embodiment.

Here, four example relationships between the temperature and the internal resistance value (in the case of a high SOC) of a battery cell are shown, where the highest temperature (highest value) is denoted by c°C and the lowest temperature (lowest value) is denoted by d°C, among a plurality of battery cells included in a battery module MDL.

On the vertical axis of FIG. 11, the relationship of A' (first temperature threshold value) [°C] > A (second temperature threshold value) [°C] > B (third temperature threshold value)[°C] is satisfied, where, for example, A' denotes a permissible upper-limit temperature taking deterioration of the battery cells into account, A denotes an upper-limit temperature of the battery cells taking the internal resistance values of the battery cells into account, and B denotes a lower-limit temperature of the battery cells taking the internal resistance values of the battery cells into account. For example, A'=55°C, A=45°C, and B=15°C.

Let us assume that the internal resistance of the highest-temperature battery cell is denoted by Rc, the internal resistance of the lowest-temperature battery cell is denoted by Rd, and the target upper-limit value (upper-limit threshold value) of the internal resistance of the battery cell is denoted by R. In this example, battery cells at a temperature of B [°C] or above have a substantially equal internal resistance value, which is equal to or lower than the upper-limit threshold value R of the internal resistance value.

The battery temperature controller 12 receives the temperature and the internal resistance value of each of the battery cells from the battery modules MDL, and selects the highest value and the lowest value among the received temperatures.

FIG. 12 is a diagram illustrating an example of temperature control of the battery cells in the storage battery device according to the second embodiment.

A case will be described where the SOCs of the battery cells are equal to or greater than 90%, or equal to or lower than 10%.

In case (1), A<c<A' and A<d<A'. Since the temperature d of the lowest-temperature battery cell is above B [°C], Rc=Rd, and hence Rc<R and Rd<R.

In this case, even though the internal resistance value of each of the battery cells falls below the upper-limit threshold value R, the battery temperature controller 12 lowers the temperature setting of the medium in such a manner that the temperature of each of the battery cells does not exceed the upper-limit temperature A' [°C], since charging and discharging of the battery cells at a high temperature causes the battery cells to deteriorate quickly.

In the case of A<c<A' and B<d<A, the battery temperature controller 12 similarly lowers the temperature setting of the medium in such a manner that the temperature of each of the battery cells does not exceed the upper-limit temperature A' [°C], since charging and discharging of the battery cells at a high temperature could cause the battery cells to deteriorate quickly.

That is, the battery temperature controller 12 outputs a temperature instruction to the cooling unit 30 to cool the medium in such a manner that the temperature of the medium falls below the value detected by the temperature detector TC when at least A<c<A' and Rd<R, thereby decreasing the temperature of each of the battery cells.

In case (2), B<c<A and B<d<A. Since the temperature d of the lowest-temperature battery cell is above B [°C], Rc=Rd, and hence Rc<R and Rd<R.

In this case, since the internal resistance value of each of the battery cells falls below the upper-limit threshold value R, and deterioration of the battery cells is suppressed, the battery temperature controller 12 controls the heating unit 20 and the cooling unit 30 in such a manner that the temperature of the medium keeps the value detected by the temperature detector TC.

In case (2), when the internal resistance value is increased by, for example, deterioration of the battery cells, resulting in Rc<R and Rd≥R, the battery temperature controller 12 may output a temperature instruction to the heating unit 20 to increase the temperature of each of the battery cells.

That is, the temperature controller 12 controls the heating unit 20 and the cooling unit 30 in such a manner that the temperature of the medium keeps the value detected by the temperature detector TC when at least B<c<A and Rd<R.

In case (3), c>B and d<B. Since the temperature d of the lowest-temperature battery cell is below B [°C], Rc<Rd, and Rc<R and Rd≥R.

In this case, since the internal resistance value of at least the lowest-temperature battery cell is above the upper-limit threshold value R, the battery temperature controller 12 outputs a temperature instruction to the heater 24 of the heating unit 20 to heat the medium in such a manner that the temperature of the medium rises above the value detected by the temperature detector TC, thereby increasing the temperature of each of the battery cells.

In case (4), c<B and d<B. Since the temperature c of the highest-temperature battery cell is below B [°C], Rc<Rd, and Rc>R and Rd≥R.

In this case, since the internal resistance values of all the battery cells are above the upper-limit threshold value R, the battery temperature controller 12 outputs a temperature instruction to the heater 24 of the heating unit 20 to heat the medium in such a manner that the temperature of the medium rises above the value detected by the temperature detector TC, thereby increasing the temperature of each of the battery cells.

Also, in this case, since there is a large number of battery cells having a high internal resistance value, as compared to case (3), the battery temperature controller 12 may perform control in such a manner that the temperature of each of the battery cells increases in a short period of time, by increasing the amount of heat applied by the heater 24.

That is, the battery temperature controller 12 outputs a temperature instruction to the heater 24 of the heating unit 20 to heat the medium in such a manner that the temperature of the medium rises above the value detected by the temperature detector TC when at least d<B and Rd≥R, thereby increasing the temperature of each of the battery cells.

The storage battery device of the present embodiment differs from the first embodiment in terms of the operation of the temperature control (step SB2) of the battery cells. That is, the battery temperature controller 12 acquires the temperature and the SOC of each of the battery cells, as in step SB21, and finds an internal resistance value of each of the battery cells by referring to a table of internal resistance values, each corresponding to the temperature and the SOC value of a battery cell, as in step SB22. Thereafter, the battery temperature controller 12 determines which of cases (1)-(4) applies, based on the internal resistance value and the temperature of each of the battery cells, and performs temperature control of the battery cells according to the appropriate case.

By performing temperature control of the battery cells by focusing on the highest value and the lowest value of the temperatures of the battery cells, as in the above-described example, it is possible to perform temperature control of the battery cells in such a manner that the internal resistance value of each of the battery cells falls within a predetermined range, even when a temperature gradient exists in the battery cells of the assembled battery BT. In addition, by performing temperature control of the battery cells based on the temperature as well as the internal resistance value of each of the battery cells, it is possible to perform temperature control with higher precision in a temperature range in which the internal resistance value becomes substantially constant, as in the range of the temperature B [°C] or above, to avoid deterioration of the battery cells and prevent increase in the internal resistance.

That is, according to the storage battery device of the present embodiment, it is possible to optimize the use of the battery cells installed in the storage battery device at an SOC ranging from 10% to approximately full charge, for example, and to improve the charging and discharging performance of the storage battery device, without increasing the number of the battery cells.

Moreover, it is possible to provide a storage battery device capable of suppressing increases in weight and outer shape of the storage battery device, while also suppressing increase in cost.

Next, a detailed description will be given of a storage battery device according to a third embodiment, with reference to the accompanying drawings.

In the present embodiment, an example of an operation of the storage battery device when a vehicle equipped with a storage battery device makes an emergency run will be described.

If a disaster occurs, for example, while a vehicle is running on power fed from overhead lines or a third rail and the feeding from the external source is stopped, it is necessary to move passengers to a safe place using the energy stored in the storage battery device.

In the case of a third rail, it is particularly difficult to move passengers to the outside of the vehicle from the viewpoint of protection against electric shock, since a feeder, corresponding to overhead lines, is positioned at the foot of the vehicle. For safety purposes, it is desirable that a vehicle be run using a storage battery device as the power supply, from the position where the vehicle has stopped upon loss of power to the next station.

For the above reasons, it is requested that the vehicle be able to move during an emergency run, optimizing the use of the energy stored in the battery cells. Thus, in the present embodiment, the storage battery device is discharged after temperature control is performed to make the internal resistance value of each of the battery cells fall within a predetermined range.

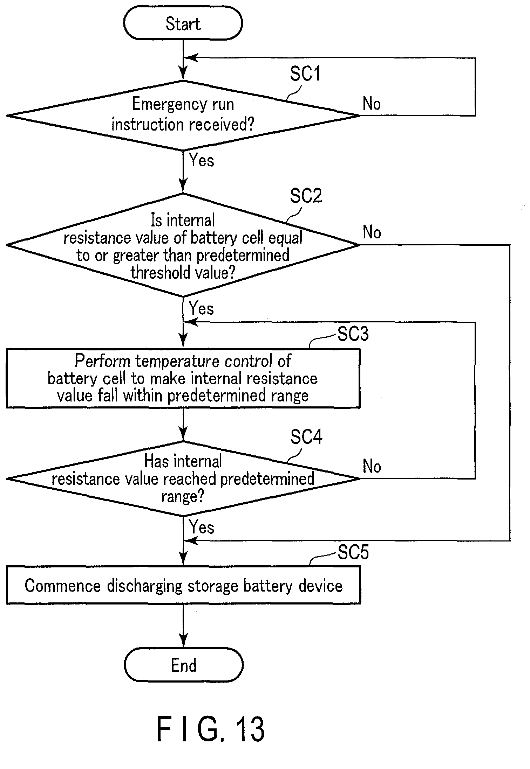

FIG. 13 is a flowchart illustrating an example of an operation of a storage battery device according to a third embodiment.

When feeding from overhead lines or a third rail has stopped and the vehicle needs to make an emergency run, the upper-level control device transmits an emergency run instruction to the storage battery device.

Upon receiving an emergency run instruction (step SC1), the battery temperature controller 12 determines whether or not the internal resistance value of each of the battery cells received from the battery modules MDL falls within a predetermined range (step SC2).

If the internal resistance value of each of the battery cells is determined as falling within the predetermined range, the battery temperature controller 12 commences discharging the storage battery device (step SC5).

If the internal resistance value of each of the battery cells is determined not to be falling within the predetermined range in step SC2, the battery temperature controller 12 performs temperature control of the battery cells in such a manner that the internal resistance value falls within a predetermined range (step SC3). In step SC3, the battery temperature controller 12 may perform temperature control of the battery cells based on the internal resistance value of each of the battery cells, as in the first embodiment (e.g, step S24), and may perform temperature control of the battery cells based on the internal resistance value and the temperature of each of the battery cells, as in the second embodiment.

The upper-limit value and the lower-limit value for the internal resistance values during an emergency run may differ from the upper-limit value and the lower-limit value during a normal run. Since temperature control is performed by, for example, controlling the heating unit 20 and the cooling unit 30 using the energy stored in the assembled battery BT, when there is a possibility that using too much energy for temperature control may cause a lack of energy to be used for a run, the upper-limit value and the lower-limit value may be adjusted in such a manner that more energy can be used for a run.

The battery temperature controller 12 performs temperature control of the battery cells until the internal resistance value of each of the battery cells reaches a predetermined range, and when the internal resistance value of each of the battery cells reaches the predetermined range (step SC4), the battery temperature controller 12 commences discharging the storage battery device (step SC5).

Next, a description will be given of an advantageous effect of the storage battery device according to the present embodiment.

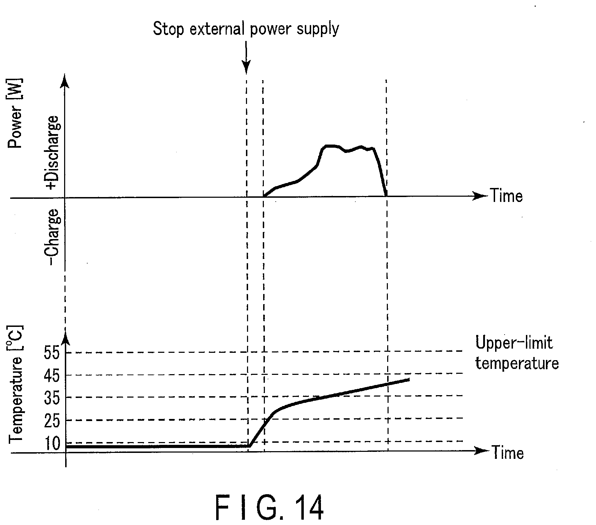

FIG. 14 shows an example of charging and discharging power of a plurality of battery modules and temperature changes of a battery cell.

For example, when there is a slope in a section through which a vehicle runs during an emergency run, the C-rate increases during discharging. In winter months and in cold climates, in particular, the temperature of each of the battery cells may become substantially equal to the outer temperature, and there is a good likelihood that the temperature of each of the battery cells decreases to a level as low as 10°C or below. When feeding is commenced from the storage battery device while the temperature of the battery cells is 10°C, there is a possibility that an amount of power required for the vehicle to climb up an upward slope may not be discharged, due to the low temperature of the battery cells.

In the example shown in FIG. 14, the battery temperature controller 12 heats the battery cells in such a manner that the internal resistance of each of the battery cells falls within a predetermined range, at the position where the external power supply has stopped, causing the vehicle to be stopped. When the internal resistance of each of the battery cells has fallen within a predetermined range, e.g., when the temperature of each of the battery cells has become equal to or greater than 25°C, the battery temperature controller 12 confirms that the internal resistance has been lowered, and commences discharging the storage battery device.

Thereby, even in the case of a loss of an external power supply in winter months or in cold climates, the vehicle is capable of running through a section in which each battery cell is assigned a heavy load for discharging, optimizing the use of the energy stored in the storage battery device, thus allowing the vehicle to run to the next station and drop off the passengers at a safe place.

That is, according to the storage battery device of the present embodiment, it is possible to optimize the use of the battery cells installed in the storage battery device at an SOC ranging from approximately 10% to approximately full charge, for example, and to improve the charging and discharging performance of the storage battery device, without increasing the number of battery cells.

In the above-described embodiments, examples have been described of a storage battery device installed in a railroad vehicle; however, applications of the storage battery device are not limited to railroad vehicles, and include other vehicles in which a storage battery device is installed. When a storage battery device is installed in another vehicle, the operation shown in FIG. 5, for example, may be omitted, and the temperature control by the battery temperature controller 12 based on the internal resistance value of each of the battery cells may be performed prior to the commencement of feeding from the storage battery device, during feeding from the storage battery device, and during charging of the storage battery device.

In the above-described embodiments, the internal resistance value of each of the battery cells is found using a table of internal resistance values, each corresponding to the temperature and the SOC of a battery cell; however, it is also possible to use an internal resistance value detected by a detector included in the cell monitoring unit 2 or the battery management unit 10, or to use a polynominal for an internal resistance value corresponding to the SOC and the temperature of each of the battery cells.

Since it is difficult to measure an SOC value while driving a vehicle, an estimated value is often used that is calculated by the battery management unit 10 based on values such as the voltage and temperature of each of the battery cells and the current of the assembled battery BT. The internal resistance value of each of the battery cells obtained based on the estimated value of the SOC may have a lower degree of precision than an internal resistance value detected by a detector. For industrial applications including a railroad vehicle in which a detector for detecting the internal resistance value can be installed, the temperature control of the battery cells can be performed with higher precision by directly measuring the internal resistance value.

Descriptions have been made of the battery management unit 10 and the battery temperature controller 12 with respect to a module in which a plurality of battery cells are installed; however, even in the case of a device or a system including a plurality of modules or in the case of a scale called a pack, the battery management unit 10 and the battery temperature controller 12, which manage one or more than one modules, can be similarly implemented by performing similar calculations.

## Claims

1. A method of operating a storage battery device installed in a railroad vehicle, wherein :
the storage battery device comprises at least one battery module (MDL) comprising an assembled battery (BT) including a plurality of battery cells, a cell monitoring unit (2) that detects a voltage and a temperature of each of the battery cells, and a temperature adjusting unit (4) that adjusts the temperature of each of the battery cells;
a heating unit (20) that heats a medium supplied to the temperature adjusting unit (4) and outputs the heated medium;
a cooling unit (30) that cools the medium supplied to the temperature adjusting unit (4) and outputs the cooled medium; and
a battery management unit (10) including a temperature detector (TC) and a battery temperature controller (12), the temperature detector (TC) configured to communicate with the cell monitoring unit (2) and an outside, and to detect a temperature of the medium, the battery temperature controller (12) performing temperature control of the battery cells by controlling the heating unit (20) and the cooling unit (30) using the temperature of the medium detected by the temperature detector (TC), a computed SOC of each of the battery cells, and the voltage and temperature of each of the battery cells received from the cell monitoring unit (2) of the battery module (MDL)to adjust a temperature of the medium,
the method comprising:
- receiving an operation plan of the railroad vehicle for a predetermined period of time from the outside, and
- computing a prediction value indicating a change over time of the SOC of the battery cell based on the operation plan, to set a time of day for performing the temperature control of the battery cells based on the operation plan, and to perform the temperature control of the battery cells.

2. The method according to claim 1, wherein the battery temperature controller (12):
controls the cooling unit (30) to cool the medium and decrease the temperature of each of the battery cells when a highest value among the temperatures of the battery cells received from the cell monitoring unit (2) is below a first temperature threshold value and above a second temperature threshold value, and an internal resistance value of a battery cell having a temperature with a lowest value among the temperatures of the battery cells is below an upper-limit threshold value for the internal resistance value;
maintains the temperature of each of the battery cells when the highest value is above a third temperature threshold value and below the second temperature threshold value, and the internal resistance value of the battery cell having the temperature with the lowest value is below the upper-limit threshold value for the internal resistance value; and
controls the heating unit (20) to heat the medium and increase the temperature of each of the battery cells when the lowest value is below the third temperature threshold value and the internal resistance value of the battery cell having the temperature with the lowest value is equal to or greater than the upper-limit threshold value for the internal resistance value.

3. The method according to claim 1 or 2, wherein the battery temperature controller (12) performs the temperature control of the battery cells in such a manner that the internal resistance value of each of the battery cells falls within a predetermined range when an emergency run instruction is received and the internal resistance value of each of the battery cells is equal to or greater than a predetermined threshold value, and commences discharging when the internal resistance value of each of the battery cells has fallen within the predetermined range.

## Patentansprüche

1. Verfahren zum Betreiben einer Speicherbatterievorrichtung, die in einem Schienenfahrzeug installiert ist, wobei:
die Speicherbatterievorrichtung mindestens ein Batteriemodul (MDL), das eine zusammengesetzte Batterie (BT) umfasst, die mehrere Batteriezellen, eine Zellenüberwachungseinheit (2), die eine Spannung und eine Temperatur jeder der Batteriezellen detektiert, und eine Temperatureinstelleinheit (4), die die Temperatur jeder der Batteriezellen einstellt, enthält;
eine Heizeinheit (20), die ein Medium erwärmt, das der Temperatureinstelleinheit (4) zugeführt wird, und das erwärmte Medium ausgibt;
eine Kühleinheit (30), die das Medium, das der Temperatureinstelleinheit (4) zugeführt wird, kühlt und das gekühlte Medium ausgibt; und
eine Batteriemanagementeinheit (10), die einen Temperaturdetektor (TC) und eine Batterietemperatur-Steuereinheit (12) enthält, wobei der Temperaturdetektor (TC) konfiguriert ist, mit der Zellenüberwachungseinheit (2) und mit der äußeren Umgebung zu kommunizieren und eine Temperatur des Mediums zu detektieren, wobei die Batterietemperatur-Steuereinheit (12) eine Temperatursteuerung der Batteriezellen durchführt, indem die Heizeinheit (20) und die Kühleinheit (30) unter Verwendung der Temperatur des Mediums, die durch den Temperaturdetektor (TC) detektiert wird, eines berechneten Batterieladezustands jeder der Batteriezellen und der Spannung und der Temperatur jeder der Batteriezellen, die von der Zellenüberwachungseinheit (2) des Batteriemoduls (MDL) empfangen werden, gesteuert werden, um eine Temperatur des Mediums einzustellen, umfasst,
wobei das Verfahren Folgendes umfasst:
- Empfangen eines Arbeitsplans des Schienenfahrzeugs für einen vorgegebenen Zeitraum von außerhalb und
- Berechnen eines Vorhersagewertes, der eine Änderung im Zeitablauf des Batterieladezustands der Batteriezelle angibt, auf der Grundlage des Arbeitsplans,
um auf der Grundlage des Arbeitsplans eine Tageszeit zum Durchführen der Temperatursteuerung der Batteriezellen einzustellen und die Temperatursteuerung der Batteriezellen durchzuführen.

2. Verfahren nach Anspruch 1, wobei die Batterietemperatur-Steuereinheit (12):
die Kühleinheit (30) derart steuert, dass das Medium gekühlt wird und die Temperatur jeder der Batteriezellen herabgesetzt wird, wenn ein höchster Wert der Temperaturen der Batteriezellen, die von der Zellenüberwachungseinheit (2) empfangen werden, unter einem ersten Temperaturschwellenwert und über einem zweiten Temperaturschwellenwert liegt und ein Wert des inneren Widerstands einer Batteriezelle, die eine Temperatur mit einem niedrigsten Wert von den Temperaturen der Batteriezellen aufweist, unter einem oberen Grenzschwellenwert für den Wert des inneren Widerstands liegt;
die Temperatur jeder der Batteriezellen aufrechterhält, wenn der höchste Wert über einem dritten Temperaturschwellenwert und unter dem zweiten Temperaturschwellenwert liegt und der Wert des inneren Widerstands der Batteriezelle, die die Temperatur mit dem niedrigsten Wert aufweist, unter dem oberen Grenzschwellenwert für den Wert des inneren Widerstands liegt; und
die Heizeinheit (20) derart steuert, dass das Medium erwärmt wird und die Temperatur von jeder der Batteriezellen erhöht wird, wenn der niedrigste Wert unter dem dritten Temperaturschwellenwert liegt und der Wert des inneren Widerstands der Batteriezelle, die die Temperatur mit dem niedrigsten Wert aufweist, größer oder gleich dem oberen Grenzschwellenwert für den Wert des inneren Widerstands ist.

3. Verfahren nach Anspruch 1 oder 2, wobei die Batterietemperatur-Steuereinheit (12) die Temperatursteuerung der Batteriezellen in der Weise durchführt, dass der Wert des inneren Widerstand jeder der Batteriezellen in einen vorgegebenen Bereich fällt, wenn eine Notfallablaufanweisung empfangen wird und der Wert des inneren Widerstands jeder der Batteriezellen größer oder gleich einem vorgegebenen Schwellenwert ist, und das Entladen beginnt, wenn der Wert des inneren Widerstands jeder der Batteriezellen in den vorgegebenen Bereich abgefallen ist.

## Revendications

1. Procédé pour faire fonctionner un dispositif à batterie de stockage installé dans un véhicule ferroviaire,
le dispositif à batterie de stockage comprenant au moins un module de batterie (MDL) comprenant une batterie assemblée (BT) comportant une pluralité de cellules de batterie, une unité de surveillance de cellules (2) qui détecte une tension et une température de chacune des cellules de batterie, et une unité de réglage de température (4) qui règle la température de chacune de cellules de batterie ;
une unité de chauffage (20) qui chauffe un milieu fourni à l'unité de réglage de température (4) et délivre le milieu chauffé ;
une unité de refroidissement (30) qui refroidit le milieu fourni à l'unité de réglage de température (4) et délivre le milieu refroidi ; et
une unité de gestion de batterie (10) comportant un capteur de température (TC) et un régulateur de température de batterie (12), le capteur de température (TC) étant configuré pour communiquer avec l'unité de surveillance de cellules (2) et l'extérieur, et pour capter une température du milieu, le régulateur de température de batterie (12) réalisant une régulation de température des cellules de batterie en régulant l'unité de chauffage (20) et l'unité de refroidissement (30) à l'aide de la température du milieu captée par le capteur de température (TC), d'un état de charge (SOC) calculé de chacune des cellules de batterie, et de la tension et de la température de chacune des cellules de batterie reçues depuis l'unité de surveillance de cellules (2) du module de batterie (MDL) dans le but de régler la température du milieu,
le procédé comprenant :
- la réception depuis l'extérieur d'un plan d'exploitation du véhicule ferroviaire pour une période prédéterminée, et
- le calcul d'une valeur de prédiction indiquant une variation dans le temps du SOC de la cellule de batterie sur la base du plan d'exploitation,
dans le but de définir une heure du jour pour la réalisation de la régulation de température des cellules de batterie sur la base du plan d'exploitation, et dans le but de réaliser la régulation de température des cellules de batterie.

2. Procédé selon la revendication 1, le régulateur de température de batterie (12) :
régulant l'unité de refroidissement (30) pour refroidir le milieu et faire baisser la température de chacune des cellules de batterie lorsque la valeur la plus élevée parmi les températures des cellules de batterie reçues depuis l'unité de surveillance de cellules (2) est inférieure à une première valeur seuil de température et supérieure à une deuxième valeur seuil de température, et qu'une valeur de résistance interne d'une cellule de batterie dont la température a la valeur la plus basse parmi les températures des cellules de batterie est inférieure à une valeur seuil de limite supérieure pour la valeur de résistance interne ;
maintenant la température de chacune des cellules de batterie lorsque la valeur la plus élevée est supérieure à une troisième valeur seuil de température et inférieure à la deuxième valeur seuil de température, et que la valeur de résistance interne de la cellule de batterie dont la température a la valeur la plus basse est inférieure à la valeur seuil de limite supérieure pour la valeur de résistance interne ; et
régulant l'unité de chauffage (20) pour chauffer le milieu et faire monter la température de chacune des cellules de batterie lorsque la valeur la plus basse est inférieure à la troisième valeur seuil de température et que la valeur de résistance interne de la cellule de batterie dont la température a la valeur la plus basse est supérieure ou égale à la valeur seuil de limite supérieure pour la valeur de résistance interne.

3. Procédé selon la revendication 1 ou 2, le régulateur de température de batterie (12) réalisant la régulation de température des cellules de batterie de telle manière que la valeur de résistance interne de chacune des cellules de batterie s'inscrive dans une plage prédéterminée lorsqu'une instruction de parcours d'urgence est reçue et que la valeur de résistance interne de chacune des cellules de batterie est supérieure ou égale à une valeur seuil prédéterminée, et déclenchant une décharge lorsque la valeur de résistance interne de chacune des cellules de batterie s'est inscrite dans la plage prédéterminée.
